# EUROPÄISCHE PATENTSCHRIFT

(11) **EP 2 927 967 B1**
(45) Veröffentlichungstag und Bekanntmachung des Hinweises auf die Patenterteilung: **21.09.2016**
(21) Anmeldenummer: 15001551.9
(22) Anmeldetag: 23.12.2005
(51) Int. Cl.: H01L 31/056, H01L 31/0687, H01L 31/0304, H01L 31/0216

(54) **Monolithische mehrfach-solarzelle**
Monolithic multiple solar cell
Cellule solaire monolithique multi-jonctions

(30) Priorität: 04.01.2005 DE 102005000767
(43) Veröffentlichungstag der Anmeldung: 07.10.2015
(62) Teilanmeldung aus: 05847317.4
(73) Patentinhaber: AZUR SPACE Solar Power GmbH, 74072 Heilbronn (DE)
(72) Erfinder: Strobl, Gerhard Dr., 70439 Stuttgart (DE); Meusel, Matthias Dr., 74076 Heilbronn (DE); Dimroth, Frank Dr., 79194 Gundelfingen (DE); Bett, Andreas Dr., 79114 Freiburg (DE)
(74) Vertreter: Koch Müller Patentanwaltsgesellschaft mbH

(56) Entgegenhaltungen:
- YAMAGUCHI M: "Multi-junction solar cells and novel structures for solar cell applications", WORKSHOP ON NANOSTRUCTURES IN PHOTOVOLTAICS 28 JULY-4 AUG. 2001 DRESDEN, GERMANY, Bd. 14, Nr. 1-2, April 2002 (2002-04), Seiten 84-90, XP008060532, Physica E Elsevier Netherlands ISSN: 1386-9477
- SHVARTS M Z ET AL: "Radiation resistant AlGaAs/GaAs concentrator solar cells with internal Bragg reflector", SOLAR ENERGY MATERIALS AND SOLAR CELLS, ELSEVIER SCIENCE PUBLISHERS, AMSTERDAM, NL, Bd. 68, Nr. 1, April 2001 (2001-04), Seiten 105-122, XP004226971, ISSN: 0927-0248
- BUSHNELL D B ET AL: "Short-circuit current enhancement in Bragg stack multi-quantum-well solar cells for multi-junction space cell applications", SOLAR ENERGY MATERIALS AND SOLAR CELLS, ELSEVIER SCIENCE PUBLISHERS, AMSTERDAM, NL, Bd. 75, Nr. 1-2, Januar 2003 (2003-01), Seiten 299-305, XP004391443, ISSN: 0927-0248
- BETT A W ET AL: "Advanced III-V solar cell structures grown by MOVPE", SOLAR ENERGY MATERIALS AND SOLAR CELLS, ELSEVIER SCIENCE PUBLISHERS, AMSTERDAM, NL, Bd. 66, Nr. 1-4, Februar 2001 (2001-02), Seiten 541-550, XP004224719, ISSN: 0927-0248
- TOBIN S P ET AL: "Enhanced light absorption in GaAs solar cells with internal Bragg reflectors", PROCEEDINGS OF THE PHOTOVOLTAIC SPECIALISTS CONFERENCE. LAS VEGAS, OCT. 7 - 11, 1991, NEW YORK, IEEE, US, Bd. VOL. 2 CONF. 22, 7. Oktober 1991 (1991-10-07), Seiten 147-152, XP010039267, ISBN: 0-87942-636-5
- Antonio Luque ET AL: "Theoretical Limits of Photovoltaic Conversion" In: "Handbook of Photovoltaic Science and Engineering", 25. April 2003 (2003-04-25), John Wiley & Sons, Ltd, Chichester, UK, XP055085053, ISBN: 978-0-47-149196-5 Seiten 113-151, DOI: 10.1002/0470014008.ch4,
- MEUSEL M ET. AL.: "European Roadmap for the Development of III-V Multi-Junction Space Solar Cells", PROCEEDINGS OF 19TH EUROPEAN PHOTOVOLTAIC ENERGY CONFERENCE, 7. Juni 2004 (2004-06-07), - 11. Juni 2004 (2004-06-11), Seiten 3581-3586, XP002369931, Paris
- HATCHER M: "Solar cell manufactures come back down to earth", COMPOUND SEMICONDUCTOR , November 2003 (2003-11), XP002369324, Gefunden im Internet: URL:www.compoundsemiconductor.net/articles /magazine/9/11/2 [gefunden am 2006-02-21]
- DIMROTH F ET AL: "3-6 junction photovoltaic cells for space and terrestrial concentrator applications", PHOTOVOLTAIC SPECIALISTS CONFERENCE, 2005. CONFERENCE RECORD OF THE THIRTY-FIRST IEEE LAKE BUENA VISTA, FL, USA 3-7 JAN. 2005, PISCATAWAY, NJ, USA,IEEE, US, 3. Januar 2005 (2005-01-03), Seiten 525-529, XP010822763, ISBN: 0-7803-8707-4
- LANTRATOV V M ET AL: "EFFECT OF THE INCREASE OF RADIATION RESISTANCE IN SOLAR CELLS WITH INTERNAL BRAGG REFLECTOR", PROCEEDINGS OF THE STATE-OF-THE-ART PROGRAM ON COMPOUND SEMICONDUCTORS, XX, XX, Bd. 97-21, 31. August 1997 (1997-08-31), Seiten 125-132, XP008057024,
- DIMROTH F ET AL: "NEXT GENERATION GaInP/GaInAs/Ge MULTI-JUNCTION SPACE SOLAR CELLS", 17TH. E.C. PHOTOVOLTAIC SOLAR ENERGY CONFERENCE. MUNICH, GERMANY, OCT. 22 - 26, 2001; [PROCEEDINGS OF THE INTERNATIONAL PHOTOVOLTAIC SOLAR ENERGY CONFERENCE], MUNICH : WIP-RENEWABLE ENERGIES, DE, Bd. CONF. 17, 22. Oktober 2001 (2001-10-22), Seiten 2150-2154, XP001139903, ISBN: 978-3-936338-08-9
- FRIEDMAN D J ET AL: "1-eV solar cells with GaInNAs active layer", JOURNAL OF CRYSTAL GROWTH, ELSEVIER, AMSTERDAM, NL, Bd. 195, Nr. 1-4, 15. Dezember 1998 (1998-12-15), Seiten 409-415, XP004154295, ISSN: 0022-0248, DOI: 10.1016/S0022-0248(98)00561-2
- DURBIN S M: 'A computational approach to the analysis of distributed Bragg reflectors in direct-gap solar cells' CONFERENCE PROCEEDINGS 13 Mai 1996 - 17 Mai 1996, Seiten 69 - 72, XP010208094

## Beschreibung

Die Erfindung bezieht sich auf eine monolithische Mehrfach-Solarzelle aus Elementen der III. und V. Hauptgruppe des Periodensystems mit integriertem Halbleiterspiegel.

Eine entsprechende Zweifach-Solarzelle - auch Tandem-Solarzelle genannt - ist aus der Literaturstelle "Prog. Photovolt: Res. Appl. 2001; 9:165 - 178, F. Dimroth et al.: Metamorphic GayIn1-YP/Ga1-xInxAs Tandem Solar Cells for Space and for Terrestrial Concentrator Applications at C>1000 Suns" bekannt. Als integrierter Halbleiterspiegel wird ein Bragg-Spiegel benutzt. Der Bragg-Spiegel wird dabei auf ein GaAs-Substrat epitaxial aufgetragen, auf dem wiederum die Zweifach-Solarzelle GalnP/GalnAs epitaxial aufgebracht wird, die eine n auf p Polarität aufweist.

Aus Physica E. 2002, Vo. 14, S. 84-90, M. Yamaguchi: "Multi-junction solar cells and novel structures for solar cell applications" sind Einfach- und Mehrfachsolarzellen bekannt, wobei bei Einfach-Solarzellen auf der Rückseite ein Bragg-Reflektor angeordnet sein kann.

Aus Journal of Electronic Materials, Vol. 21, No. 3, 1992, S. M. Vernon et al.: "Growth and Characterization of AlxGa1-xAs Bragg Reflectors by LP-MOCVD" ist eine GaAs¬Solarzelle mit einem Bragg-Reflektor auf einem Siliziumsubstrat bekannt.

Auch aus der Literaturstelle "Solar Energy Materials & Solar Cells 68 (2001) 105 ¬122, M. Z. Shvarts et al.: Radiation resistant AlGaAs/GaAs concentrator solar cells with inter-nal Bragg reflector" ist eine GaAs-Einfachsolarzelle bekannt, Unter der ein Bragg-Spiegel angeordnet ist. Bei der verwendeten Solarzelle handelt es sich um eine solche mit p auf n Polarität.

Aus der WO-A-2004/017425 ist eine Mehrfach-Solarzelle bekannt, bei der zwischen einzelnen Solarzellen Rückseiten-Reflektoren verlaufen, die die Funktion von elektrischen Spiegeln gegenüber Minoritätsladungsträger ausüben.

Gitterangepasste 3-fach Solarzellen aus Ga_{0,5}In_{0,5}P/Ga_{0,99}IN_{0,01}As/Ge sind Marktführer unter den Weltraumsolarzellen. Beste Zellen erreichen 30-31 % Wirkungsgrad unter dem Weltraumsonnenspektrum AMO. In der Produktion wurde bisher maximal ein durchschnittlicher Wirkungsgrad von mindestens 28.3 % erreicht. Ein entscheidender Faktor ist die Strahlungshärte der Zellen. Nach einer typischen Bestrahlung mit 1x10¹⁵ cm⁻² 1MeV Elektronen degradiert der Wirkungsgrad dieser Zellen auf 24.3 %. Dies entspricht einem Restfaktor von 86 %.

5- und 6-fache Solarzellen werden in "M. Hatcher: Solar cell manufacturers come back down to earth", Compondsemiconductor.net Magazine, November 2003, beschrieben.

Der vorliegenden Erfindung liegt die Aufgabe zu Grunde, eine monolithische Mehrfach-Solarzelle der eingangs genannten Art so weiterzubilden, um die Strahlungsstabilität zu verbessern, so dass der end-of-life-(EOL)Wirkungsgrad erhöht wird. Gleichzeitig soll die Stromgeneration der einzelnen Teilzellen nicht wesentlich beeinträchtigt werden. Dabei soll der Aufwand bei der Herstellung der Solarzelle nicht merklich beeinflusst werden.

Erfindungsgemäß wird die Aufgabe im Wesentlichen dadurch gelöst, dass die Mehrfach-Solarzelle zumindest drei Teilzellen umfasst, dass der Halbleiterspiegel zwischen zwei Teilzellen angeordnet ist und mehrere Schichten mit zumindest voneinander abweichendem Brechungsindex aufweist und dass der Halbleiterspiegel einen hohen Reflexionsgrad in zumindest einem Teil des Absorptionsbereichs der über dem Halbleiterspiegel angeordneten Teilzelle oder Teilzellen und einen hohen Transmissionsgrad für Strahlung im spektralen Absorptionsbereich der unterhalb des Halbleiterspiegels angeordneten Teilzelle oder Teilzellen aufweist.

Mit Reflexionsgrad R wird hier die wellenlängenabhängige Reflexion gemittelt über einen bestimmten Spektralbereich bezeichnet. Idealerweise umfasst dieser Spektralbereich den gesamten spektralen Absorptionsbereich der über dem Halbleiterspiegel liegenden Teilzelle. In der Anwendung ist oft ein kleinerer Spektralbereich ausreichend, insbesondere ein Reflexionsband nahe der Bandlückenenergie der darüber liegenden Teilzelle mit einer Halbwertsbreite HWB von 40 nm ≤ HWB ≤ 300 nm.

Ein hoher Reflexionsgrad R bedeutet dabei, dass die mittlere Reflexion über dem Reflexionsband R ≥ 0,3, vorzugsweise R ≥ 0,7, insbesondere 0,7 ≤ R ≤ 1 beträgt. Mit Transmissionsgrad T wird hier die wellenlängenabhängige Transmission, gemittelt über den spektralen Absorptionsbereich der unter dem Halbleiterspiegel liegenden Teilzelle bzw. Teilzellen, bezeichnet. Ein hoher Transmissionsgrad T bedeutet dabei, dass T ≥ 0,5, vorzugsweise T ≥ 0,85, insbesondere 0,9 ≤ T ≤ 1 beträgt.

Erfindungsgemäß wird ein optischer Spiegel in Form eines monolithisch integrierten Halbleiterspiegels für Mehrfach-Solarzellen bestehend bzw. umfassend Verbindungshalbleiter der III- und V-Gruppe des Periodensystems vorgeschlagen, wobei die Mehrfach-Solarzelle drei oder mehr Teilzellen umfasst. Dabei wird der Halbleiterspiegel unter der n-ten Solarzelle der Mehrfach-Solarzelle durch ein geeignetes Epitaxieverfahren eingebaut. Geeignete Epitaxieverfahren sind zum Beispiel MOVPE (Metal-Organie-Vapour-Phase Epitaxy) oder MBE (Molecular Beam Epitaxy) oder VPE (Vapor Phase Epitaxy), um nur einige Verfahren zu nennen.

Der Halbleiterspiegel besteht aus mehreren dünnen Halbleiterschichten mit unterschiedlichem Brechungsindex. Dabei ist die Anzahl, Folge und Dicke der Schichten so gewählt, dass ein Teil des Sonnenspektrums in die n-te Teilzelle der m-Teilsolarzellen umfassend Mehrfachsolarzellen zurückreflektiert wird. Dabei ist m > n sowie m = 3. Durch die Verwendung eines solchen Spiegels kann die Dicke der n-ten Teilzelle halbiert werden, ohne die Absorption in der Teilzelle stark zu reduzieren. Gleichzeitig sind die Schichten so gewählt, dass der Halbleiterspiegel eine hohe Transmission in einem anderen Teil des Sonnenspektrums besitzt. Hierdurch wird sichergestellt, dass die Stromgeneration in der (n+1)-ten Teilzelle, also derjenigen, die unterhalb des Halbleiterspiegels verläuft, sowie den weiteren unterhalb des Halbleiterspiegels liegenden Teilzellen nicht über ein kritisches Maß hinaus reduziert wird.

Der Einbau eines entsprechenden Halbleiterspiegels ist insbesondere dann von besonderem Vorteil, wenn eine der Teilzellen der Mehrfach-Solarzelle aus Material mit einer niedrigen Diffusionslänge besteht, bzw. wenn sich die Diffusionslänge in einer der Teilzellen während der Anwendung wesentlich verschlechtert. Durch die Verwendung des Halbleiterspiegels kann die Dicke der n-ten Teilzelle halbiert werden, ohne die Absorption in dieser Teilzelle stark zu reduzieren. Die Kombination aus Einführung eines Halbleiterspiegel und gleichzeitiger Verringerung der Zelldicke wirkt sich positiv auf die Stromgeneration aus. Zum einen ergibt sich ein günstigeres Generationsprofil über die Tiefe der aktiven Schichten der Teilzelle. Besonders bedeutsam ist es, dass sich durch die geringere Zelldicke der mittlere Abstand der erzeugten Minoritätsladungsträger von der Raumladungszone stark verringert. Dies führt zu einer erhöhten Wahrscheinlichkeit, dass die Minoritätsladungsträger während der Diffusion auf die Raumladungszone treffen und somit zur Stromgeneration beitragen. Die Rekombination wird somit verringert.

Ein wichtiges Anwendungsbeispiel ist die Ga_{0.5}IN_{0.5}P/Ga_{0.99}In_{0,01}As/Ge 3-fach Solarzelle, die in den letzten Jahren zur am meisten angewendeten Solarzelle auf Satelliten geworden ist Im Weltraum sind die Solarzellen einem Spektrum von hochenergetischen Teilchen, zum Beispiel Elektronen und Protonen mit Energien im MeV Bereich, ausgesetzt. Diese Strahlung kann zu. einer Degradation der Solarzelle, insbesondere zu erhöhter Rekombination und damit zu einer geringen Diffusionslänge im Halbleitermaterial führen. Während die GaInP Oberzelle und die Ge Unterzelle relativ unempfindlich auf die Weltraumstrahlung sind, zeigt die Ga_{0,99}In_{0,01}As Mittelzelle eine starke Degradation. Bei typischen Strahlungsdosen, wie etwa 1 x 10¹⁵ cm⁻² 1 MeV Elektronen, nimmt die Diffusionslänge in Ga_{0.99}In_{0,01}As so stark ab, dass nur noch ein Teil der erzeugten Minoritätsladungsträger die Raumladungszone erreicht. Eine starke Degradation des generierten Stromes bzw. der Quanteneffizienz der Mittelzelle ist die Folge. Die Degradation der Mittelzelle bestimmt somit die Degradation der 3-fach Solarzelle. Durch das erfindungsgemäße Einfügen des Halbleiterspiegels zwischen Mittel- und Unterzelle und gleichzeitiges Halbieren der Dicke der Mittelzelle kann diese Degradation deutlich verringert werden. Die Schichten des Halbleiterspiegels werden in diesem Fall so gewählt, dass eine hohe Reflexion im Spektralbereich höherer Energien als die der Bandlücke von Ga_{0,99}In_{0,1}As von ca. 1.4 eV erreicht wird. Gleichzeitig muss eine ausreichende Transmission für kleinere Energien erreicht werden, so. dass in der Ge Unterzelle noch ausreichend Strom generiert wird. Im Falle der Ga_{0.5}In_{0,5}P/Ga_{0,99}In_{0,01}AsIGe 3-fach Solarzelle generiert die Ge Unterzelle einen Überschuss au Strom (ca. 30 mA/cm² im Vergleich zu den oberen Teilzellen mit ca. 17 mA/cm²), wodurch die Anforderungen an die Transparenz des Halbleiterspiegels für kleinere Energien nicht ganz so hoch sind.

Während im Falle der Ga_{0.5}In_{0,5}P/Ga_{0,99}In_{0,01}As/Ge 3-fach Solarzelle alle Teilzellen mit der gleichen Gitterkonstante gitterangepasst zum Substrat gezüchtet sind, werden in der Entwicklung zur Zeit 3-fach Solarzellen untersucht, welche aus gitterfehlangepassten Schichten bestehen. Typische Materialkombinationen sind hier GalnP/GalnAs/Ge oder auch AIGalnP/GalnAs/Ge, wobei der Indium Gehalt in einer oder in beiden der oberen Teilzellen höher ist, als in der zuvor genannten 3-fach Solarzelle. Die Anwendung des erfindungsgemäßen Halbleiterspiegels für diese Zellkonzepte ist analog. Die Anforderungen an die Transparenz des Halbleiterspiegels für kleinere Energien als die der Energiebandlücke des verwendeten GalnAs ist hier etwas höher, da der Überschuss an Generation in der Ge Unterzelle hier geringer ist.

Analog lässt sich der Halbleiterspiegel auch für gitterangepasste und gitterfehlangepasste 5-fach Solarzellen anwenden, welche zur Zeit ebenfalls für die Weltraumanwendung entwickelt werden. AlGalnP/GalnP/AlGalnAs/GalnAs/Ge ist z. B. eine typische Materialkombination für eine solche Zelle.

Während bei den zuvor diskutierten Zellkonzepten das Problem der niedrigen Diffusionslänge durch die Anwendung im Weltraum und die dort herrschende Strahlung zu Stande kommt, gibt es auch Konzepte für Mehrfach-Solarzellen, welche Materialien mit inherent niedriger Diffusionslänge beinhalten. Ga_{0.5}In_{0,5}P/Ga_{0,99}In_{0,01}As/Ge 3-fach Solarzellen lassen sich unter Hinzunahme einer weiteren Teilzelle eines Materials mit einer Energiebandlücke von ca. 1eV zu Ga_{0.5}In_{0,5}P/Ga_{0,99}In_{0,01}As/Ge 1eV-Material/Ge 4-fach Solarzellen erweitern. Mit dem Material GalnNAs lässt sich z. B. eine Energiebandlücke von 1 eV bei gleichzeitiger Gitteranpassung zum Ge Substrat realisieren. Dieses Material zeigt jedoch bisher sehr niedrige Diffusionslängen, weswegen noch keine besseren Ergebnisse mit 4-fach Solarzellen erreicht wurden als mit 3-fach Solarzellen.

Der analoge Einbau eines Halbleiterspiegels unter der GalnNAs Teilzelle bei gleichzeitiger Anpassung der Zelldicke kann in diesem Fall ebenfalls erfolgreich angewendet werden. Dabei werden die Schichten des Halbleiterspiegels so gewählt werden, dass eine hohe Reflexion für Energien größer 1 eV und gleichzeitig eine hohe Transmission für Energien kleiner 1 eV erreicht wird. Die Anforderungen an die Transparenz des Halbleiterspiegels für kleinere Energien sind hier sehr hoch, da die Ge Unterzelle über keinen Überschuss an Generation verfügt. Eine solche 4-fach Solarzelle ist nicht nur für die Anwendung im Weltraum, sondern auch für die Anwendung in terrestrischen Konzentratorsystemen geeignet.

Des Weiteren sind 6-fach Solarzellen für die Weltraumanwendung bekannt. Diese erhält man z. B. aus der Erweiterung einer AlGalnP/GalnP/AlGalnAs/GalnAs/Ge 5-fach Solarzelle mit einer weiteren Teilzelle eines Materials mit einer Energiebandlücke von ca. 1.0-1.1 eV. Eine mögliche Materialkombination ist somit AlGaInP/GaInP/AlGaInAs/GaInAs/GaInNAs/ Ge. Entsprechend der erfindungsgemäßen Lehre erfolgt der Einbau eines oder sogar zweier Halbleiterspiegel.

Beispiele für Mehrfach-Solarzellen sind aus der Literaturstelle "Proceedings of 19th European Photovoltaic Energy Conference, 7. - 11. Juni 2004, Paris, S. 3581 - 3586, M. Meusel et al.: "European Roadmap for the Development of III-V Multi-Junction Space Solar Cells" zu entnehmen.

Wird üblicherweise für die Epitaxie einer Mehrfach-Solarzellenstruktur ein Ge-Substrat verwendet, das während die Epitaxie aktiviert wird und die Ge-Unterzelle bildet, ist die erfindungsgemäße Lehre analog auch für Solarzellen anwendbar, bei der die Epitaxie auf ein Silizium- oder Si/Ge-Substrat erfolgt.

Unabhängig hiervon sieht eine Weiterbildung der Erfindung vor, dass die der nachfolgenden Teilzelle vorausgehende Schicht des Halbleiterspiegels eine Gitterstruktur aufweist, die der der Teilzelle angepasst ist.

Die Schichten des Halbleiterspiegels bestehen aus Verbindungshalbleiter der III. und V. Hauptgruppe des Periodensystems bzw. enthalten diese. Dabei können die Verbindungshalbleiter mit Si, Te, Zn, C, Mg und/oder Se dotiert sein.

Die Schichten können aus Verbindungshalbleitermaterial wie AlGaInAs-Material und/oder AlGaInP-Material bestehen oder dieses enthalten, wobei AlGaInAs einschließt GaAs, InAs AlAs, GalnAs AlGaAs, AlInAs und/oder AlGaInP einschließt GaP; InP A1P, GaInP oder AlInP.

Jeweilige Schicht des Halbleiterspiegels sollte eine Dicke d mit 2 nm ≤ d ≤ 300 nm, insbesondere 10 nm ≤ d ≤ 150 nm aufweisen.

Der Halbleiterspiegel besteht aus n-Schichten, wobei 10 ≤ n ≤ 50, insbesondere 15 ≤ n ≤ 35 ist. Die Gesamtdicke D des Halbleiterspiegels sollte betragen 500 nm ≤ D ≤ 4000 nm, insbesondere 750 nm ≤ D ≤ 2500 nm.

Ganz allgemein lehrt die Erfindung, dass bei n-Schichten des Halbleiterspiegels mindestens zwei Schichten einen unterschiedlichen Brechungsindex und/oder zumindest zwei Schichten eine unterschiedliche Materialzusammensetzung und/oder zumindest zwei Schichten unterschiedliche Dicken aufweisen. Selbstverständlich können auch drei oder mehr Schichten eine unterschiedliche Materialzusammensetzung bzw. unterschiedliche Brechungsindices bzw. unterschiedliche Dicken aufweisen.

Durch die Vielzahl der unterschiedlichen Materialschichten ergeben sich insbesondere vorteilhafte Eigenschaften in Bezug auf Reflexion und Transmission sowie die Möglichkeit der Passivierung der Grenzfläche zur darüber liegenden Teilzelle.

Insbesondere sieht die Erfindung vor, dass der Halbleiterspiegel zwischen Mittel- und Unterzelle einer GaInP/GaInAsIGe-Dreifachsolarzelle eingebaut ist, wobei bevorzugterweise die GaInAs-Mittelzelle eine Dicke dₘ mit 500 ≤ dₘ ≤ 2500 nm, insbesondere 800 nm ≤ dₘ ≤ 2000 nm aufweist.

Des Weiteren sieht die Erfindung vor, dass ein oder mehrere Halbleiterspiegel in eine GaInP/GalnAs/GaInNAs/Ge-Verfachsolarzelle eingebaut sind, wobei ein Halbleiterspiegel insbesondere zwischen der GaInNAs- und der Ge-Teilzelle angeordnet ist.

Ein Einbau eines Halbleiterspiegels ist auch in einer Fünffach-Solarzelle möglich, die zum Beispiel aus den Teilzellen AlGaInP/GaInP/AlGaInAs/GaInAs/Ge besteht, wobei der Halbleiterspiegel zwischen der GalnAs- und der Ge-Teilzelle angeordnet sein sollte.

Wird eine Sechsfach-Solarzelle benutzt, in der ein oder mehrere Halbleiterspiegel eingebaut sind, so sollte die Solarzelle aus den Teilzellen AlGaInP/ GaInP/AlGaInA.s/GaInAs/GaInNAs/Ge bestehen.

Ein besonders guter EOL-Wirkungsgrad lässt sich dann erzeugen, wenn der Halbleiterspiegel eine hohe Halbwertsbreite aufweist. Optimal wäre eine Halbwertbreite (HWB), die den gesamten Absorptionsbereich der darüber liegenden Teilzelle einschließt. Hierdurch würden jedoch Einschränkungen im Reflexionsgrad in Kauf zu nehmen sein bzw. ein hoher Materialverbrauch wäre notwendig. Um eine Optimierung zu erzielen, sollte die Halbwertsbreite zwischen 50 nm und 300 nm, insbesondere zwischen 80 nm und 150 nm liegen.

Die Schichten des Halbleiterspiegels sollten femer derart ausgelegt sein, dass der Reflexionsgrad R beträgt R ≥ 0,3, insbesondere R ≥ 0,7, vorzugsweise 0,7 ≤ R ≤ 1 und der Transmissionsgrad T beträgt T ≥ 0,5, insbesondere T ≥ 0,85, vorzugsweise 0,9 ≤ T ≤ 1.

Ein Spezialfall des erfindungsgemäßen. Halbleiterspiegels ist der Bragg-Reflektor. Dieser besteht üblicherweise aus einem periodischen Übergitter aus 2 Materialien mit unterschiedlichem Brechungsindex. Die Dicke der jeweiligen Schichten eines Materials ist konstant. Hierdurch können je nach der Anzahl der Übergitterperioden Reflexionen bis nahe an 100 % erzielt werden. Die Bragg-Spiegel werden zum Beispiel in oberflächenemittierenden Lasern eingesetzt.

Ganz allgemein stellt der erfindungsgemäße die Funktion eines optischen Spiegels aufweisende Halbleiterspiegel in Bezug auf die über diesem angeordneten Teilzellen einen überaus guten Reflektor und in Bezug auf die unterhalb des Halbleiterspiegels angeordneten Teilzelle einen Langpassfilter dar.

Die erfindungsgemäße Lehre ist insbesondere dann vorteilhaft anzuwenden, wenn eine der Teilzellen eine Mehrfach-Solarzelle aus einem Material mit einer niedrigen Diffusionslänge besteht bzw. wenn sich die Diffusionslänge in einer der Teilzellen während der Anwendung wesentlich verschlechtert. Durch die Verwendung des Halbleiterspiegels kann die Dicke der n-ten Teilzelle halbiert werden, ohne dass die Absorption in der Teilzelle wesentlich reduziert wird. Die Kombination aus Einbau eines Halbleiterspiegels und gleichzeitiger Verringerung der Zeltdicke wirkt sich positiv auf die Stromgeneration aus. Zum einen ergibt sich ein günstigeres Regenerationsprofil über die Tiefe der aktiven Schichten der Teilzelle, zum anderen verringert sich durch die geringere Zeltdicke der mittlere Abstand der erzeugten Minoritätsladungsträger von der Raumladungszone stark. Dies führt zu einer erhöhten Wahrscheinlichkeit, dass die Minoritätsladungsträger während der Diffusion auf die Raumladungszone treffen und somit zur Stromgeneration beitragen. Die Rekombination wird folglich verringert. Demzufolge wird aufgrund der erfindungsgemäßen Lehre eine Steigerung des in einer Teilzelle generierten Stromes erreicht, der durch eine niedrige Diffusionslänge begrenzt wird. Insbesondere kann die Strahlungsstabilität der Ga_{0,99}In_{0,01}As Mittelzelle einer Ga_{0,5}In_{0,5}P/Ga_{0,99}In_{0,01}As/Ge 3-fach Solarzelle deutlich verbessert werden.

Durch den Einbau eines Halbleiterspiegels kann des Weiteren die Gesamtdicke der Mehrfach-Solarzellenstruktur verringert werden. Entsprechende Verbesserungen der Strahlungsstabilität ergeben sich im Fall der Ga_{0,99}In_{0,01}As - oder gitterfehlangepassten GaInAs-Teilzellen in Mehrfach-Solarzellen mit drei oder mehr Teilzellen. Zur erfolgreichen Anwendung von neuen Materialien mit niedriger Diffusionslänge wie GalnNAs als Teilzelle in einer Mehrfach-Solarzelle kann analog zur erfindungsgemäßen Lehre, der Einbau eines Halbleiterspiegels einen entscheidenden Beitrag leisten.

Der Halbleiterspiegel zeichnet sich durch geeignete Materialien aus, wobei eine Gitteranpassung zur auf dem Halbleiterspiegel angeordneten Teilzelle erfolgt. Dabei gelangen zumindest zwei Materialien mit einem hohen Unterschied im Brechungsindex zum Einsatz, um eine hohe Reflexion zu erreichen. Materialien mit einer gleich großen oder größeren Bandlücke als die der darüber liegenden Teilzelle gelangen zum Einsatz, damit eine Absorption für kleinere Energien nicht stattfindet. Durch den Einbau des Halbleiterspiegels kann die Dicke der auf dem Halbleiterspiegel aufgebrachten Teilzelle reduziert, insbesondere halbiert werden.

Zum Ausbilden des Halbleiterspiegels gelangen übliche Epitaxieverfahren zur Anwendung, die die Abscheidung zahlreicher Schichten aus unterschiedlichen Materialien erlaubt. Beispielhaft sind MOVPE, MBE, VPE etc. zu nennen. Dabei wird der Halbleiterspiegel während der Epitaxie der Solarzellenstruktur mit abgeschieden.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Abb. 1: ein schematischer Aufbau einer Mehrfach-Solarzelle mit integriertem Halbleiterspiegel,
- Abb. 2: Reflexion eines idealen Halbleiterspiegels und
- Abb. 3: simulierte Reflexion eines Halbleiterspiegels.

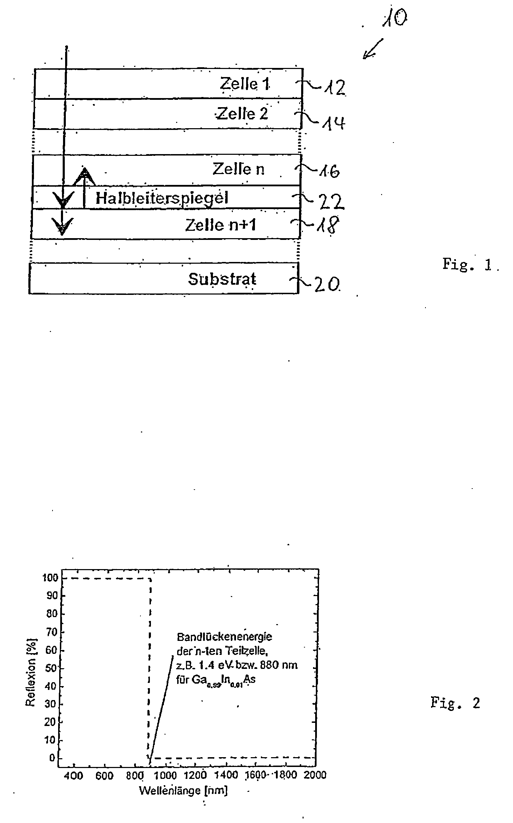

Der Abb. 1 ist ein schematischer Aufbau einer Mehrfach-Solarzelle 10 mit einem erfindungsgemäß eingebauten Halbleiterspiegel zu entnehmen. Die Solarzelle 10 besteht aus m-Teilzellen 12, 14, 16, 18, die epitaxial auf einem Substrat 20 aufgetragen worden sind. Zwischen der (n)-ten Zelle 16 mit m > n und der (n+1)-ten Zelle 18 ist ein Halbleiterspiegel 22 eingebaut, der während der Epitaxie der Solarzellenstruktur mit abgeschieden worden ist. Als geeignetes Epitaxieverfahren kommen solche in Frage, die für die Abscheidung zahlreicher Schichten aus unterschiedlichen Materialien geeignet sind. Beispielhaft sind MOVPE, MBE (Molecular Beam Epitaxy) oder VPE (Vapor Phase Epitaxy) zu nennen, ohne dass hierdurch eine Einschränkung der erfindungsgemäßen Lehre erfolgt.

Insbesondere handelt es sich bei der Mehrfach-Solarzelle 10 um eine 3-fach Solarzelle, wobei die Oberzelle aus Ga_{0,5}In_{0,5}P, die Mittelzelle aus Ga_{0,99}In_{0,01}As und die Unterzelle aus Ge bestehen. Der aus mehreren Schichten bestehende Halbleiterspiegel 22 ist insbesondere zwischen der Unterzelle aus Ge und der Mittelzelle Ga_{0,99}In_{0,01}As eingebaut. Dabei ist der Schichtaufbau derart, dass zumindest zwei Schichten aus unterschiedlichen Materialien, voneinander abweichenden Dicken und unterschiedlichem Brechungsindex bestehen.

Durch die Auswahl der Materialien, Schichtdicken und Brechungsindizes ergibt sich im Idealfall ein Reflektionsverhalten, wie dieses der Abb. 2 zu entnehmen ist. So ergibt sich für Energien größer der Bandlückenenergie der n-ten Teilzelle eine maximale Reflexion, also im Ausführungsbeispiel der 3-fach Zelle mit einer Ga_{0,99}In_{0,01}As Mittelzelle bei einer Bandlückenenergie > 1,4 eV bzw. 880 nm eine maximale Reflexion. Für Energien kleiner der Bandlückenenergie der n-ten Zelle ist die Reflexion minimal bzw. die Transmission maximal. Dabei können Transmissionsverluste durch Absorption im Halbleiterspiegel durch die Wahl geeigneter Materialien zum Beispiel GaAs und AIGaAs vermieden bzw. vernachlässigbar klein werden.

Die oberste Schicht des Halbleiterspiegels 22 kann aus GaInP bestehen und zugleich das Rückseitenfeld für die darüber liegende Mittelzelle Ga_{0,99}In_{0,01}As sein. GaInP wird dabei als Material verwendet, da dieses sehr gute Eigenschaften als Rückseitenpassivierung aufweist. Die übrigen Schichten des Halbleiterspiegels 22 bestehen im Ausführungsbeispiel aus drei unterschiedlichen Materialien: Ga_{0,99}In_{0,01}As, Al_{0,2}Ga_{0.8}As und Al_{0,2}Ga_{0,8}As. Hierin besteht ein wesentlicher Unterschied zum klassischen Bragg-Reflektor, welcher aus nur zwei unterschiedlichen Materialien besteht. Zusätzlich werden in dem Beispiel unterschiedlichste Schichtdicken verwendet, während beim klassischen Bragg-Reflektor alle Schichten eines Materials die gleiche Dicke aufweisen.

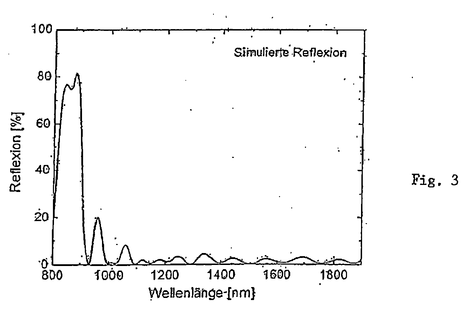

Ein weiteres wesentliches Merkmal der Schichtfolge des Halbleiterspiegels 22 ist, dass diese zum einen eine hohe Reflexion für Energien oberhalb der Bandkante der darüber liegenden Teilzelle erreicht, zum anderen aber auch eine niedrige Reflexion bzw. hohe Transmission für niedrigere Energien besitzt. Zur Veranschaulichung ist in Abb. 3 die berechnete Reflexion des Halbleiterspiegels an der Grenzfläche zur darüber liegenden Ga_{0,99}In_{0,01}As Teilzelle gezeigt. Für Wellenlängen zwischen 800 nm und 900 nm wird eine hohe Reflexion erreicht. Für Wellenlängen größer 900 nm ist die Reflexion hingegen gering. Dies ist eine wichtige Eigenschaft des Halbleiterspiegels um sicher zu stellen, dass die Stromgeneration in der Ge Unterzelle nicht wesentlich durch den Halbleiterspiegel 22 reduziert wird.

## Patentansprüche

1. Monolithische Mehrfach-Solarzelle (10) im Wesentlichen aus Elementen der III. und V. Hauptgruppe des Periodensystems bestehend, wobei die Mehrfach-Solarzelle (10) zumindest drei Teilzellen (12, 14, 16, 18) umfasst von denen eine Teilzelle eine GaInAs-Teilzelle ist und auf einem Ge-Substrat aufgebaut ist,
**dadurch gekennzeichnet, dass** unter der GaInAs-Teilzelle ein Halbleiterspiegel (22) angeordnet ist, und dass der Halbleiterspiegel (22) mehrere Schichten voneinander abweichendem Brechungsindex und/oder Materialzusammensetzung und/oder Dicke aufweist, und wobei die Dicke d der Schichten des Halbleiterspiegels (22) mit 10 nm ≤ d ≤ 150 nm ist und der Halbleiterspiegel (22) aus n-Schichten mit 10 ≤ n ≤ 50 besteht und die Halbwertsbreite HWB des Halbleiterspiegels (22) mit 50 nm ≤ HWB ≤ 300 nm ist und dass der Halbleiterspiegel in einem Teil des spektralen Absorptionsbereichs der über dem Halbleiterspiegel angeordneten Teilzelle (16) oder Teilzellen (12, 14, 16) einen hohen Reflexionsgrad und im spektralen Absorptionsbereich der unterhalb des Halbleiterspiegels angeordneten Teilzelle (18) oder Teilzellen einen hohen Transmissionsgrad aufweist.

2. Mehrfach-Solarzelle nach Anspruch 1, **dadurch gekennzeichnet, dass** die Schichten des Halbleiterspiegels (22) aus Verbindungshalbleitern der III. und V. Hauptgruppe des Periodensystems bestehen oder diese enthalten und insbesondere mit Si, Te, Zn, C, Mg und/oder Se dotiert sind.

3. Mehrfach-Solarzelle nach Anspruch 1 oder 2, **dadurch gekennzeichnet, dass** die unmittelbar unter der darüberliegenden Teilzelle (16) ausgebildete Schicht des Halbleiterspiegels (22) das Rückseitenfeld der Teilzelle bildet, das insbesondere aus AlGaInP besteht.

4. Mehrfach-Solarzelle nach zumindest einem der vorhergehenden Ansprüche, **dadurch gekennzeichnet, dass** die Schicht bzw. Schichten des Halbleiterspiegels (22), die unmittelbar unterhalb der nachfolgenden Teilzelle (16) angeordnet sind, an die Teilzelle (16) gitterangepasst sind.

5. Mehrfach-Solarzelle nach zumindest einem der vorhergehenden Ansprüche, **dadurch gekennzeichnet, dass** der Halbleiterspiegel (22) Materialien mit einer gleich großen oder größeren Bandlückenenergie wie bzw. als die darüber liegende Teilzelle (16) aufweist.

6. Mehrfach-Solarzelle nach zumindest einem der vorhergehenden Ansprüche, **dadurch gekennzeichnet, dass** die Schichten des Halbleiterspiegels (22) aus Verbindungshalbleitern in Form von AllGaInAs-Material und/oder AlGaInP-Material bestehen, wobei insbesondere das AIGaInAs-Material GaAs, InAs, AlAs, GalnAs AlGaAs, AlInAs und/oder das AlGaInP-Material GaP, InP AlP, GaInP und/oder AlInP einschließt.

7. Mehrfach-Solarzelle nach zumindest einem der vorhergehenden Ansprüche, **dadurch gekennzeichnet, dass** der Halbleiterspiegel (22) aus zumindest drei Schichten mit unterschiedlichem Brechungsindex und/oder aus zumindest drei Schichten mit unterschiedlicher Zusammensetzung und/oder mit unterschiedlicher Dicke besteht.

8. Mehrfach-Solarzelle nach einem der vorhergehenden Ansprüche, **dadurch gekennzeichnet, dass** der Halbleiterspiegel (22) eine Gesamtdicke D mit 500 nm s D ≤ 4000 nm, aufweist, und wobei der Halbleiterspiegel (22) aus n-Schichten mit 15 ≤ n ≤ 35 besteht.

9. Mehrfach-Solarzelle nach einem der vorhergehenden Ansprüche, **dadurch gekennzeichnet, dass** Halbleiterspiegel (22) eine Gesamtdicke D mit 750 nm ≤ D ≤ 2500 nm aufweist.

10. Mehrfach-Solarzelle nach einem der vorhergehenden Ansprüche, **dadurch gekennzeichnet, dass** mehrere Halbleiterspiegel (22) eingebaut sind.

11. Mehrfach-Solarzelle nach zumindest einem der vorhergehenden Ansprüche, **dadurch gekennzeichnet, dass** der Reflexionsgrad R des Halbleiterspiegels (22) der Strahlung in einem Teil des spektralen Absorptionsbereichs der über dem Halbleiterspiegel angeordneten Teilzelle (16) bzw. angeordneten Teilzellen (12, 14, 16) sich beläuft auf 0,7 ≤ R ≤ 1.

12. Mehrfach-Solarzelle nach zumindest einem der vorhergehenden Ansprüche, **dadurch gekennzeichnet, dass** der Halbleiterspiegel (22) Transmissionsgrad T des Halbleiterspiegels (22) der Strahlung im spektralen Absorptionsbereich der unterhalb des Halbleiterspiegels angeordneten Teilzelle bzw. Teilzellen sich beläuft auf 0,8 ≤ T ≤ 1.

## Claims

1. Monolithic multiple solar cell (10) consisting substantially of elements of the III and V main group of the periodic system, wherein the multiple solar cell (10) comprises at least three sub-cells (12, 14, 16, 18), of which one sub-cell is a GaInAs sub-cell and is constructed on a Ge substrate, **characterised in that** a semiconductor mirror (22) is arranged under the GalnAs sub-cell and that the semiconductor mirror (22) comprises a plurality of layers of mutually different index of refraction and/or material composition and/or thickness, and wherein the thickness d of the layers of the semiconductor mirror (22) is 10 nm ≤ d ≤ 150 nm and the semiconductor mirror (22) consists of n layers with 10 ≤ n ≤ 50 and the half-width HWB of the semiconductor mirror (22) is 50 nm ≤ HWB ≤ 300 nm and that the semiconductor mirror in a part of the spectral absorption range of the sub-cell (16) or sub-cells (12, 14, 16) arranged above the semiconductor mirror has a high reflectivity and in the spectral absorption range of the sub-cell (18) or sub-cells arranged below the semiconductor mirror has a high transmissivity.

2. Multiple solar cell according to claim 1, **characterised in that** the layers of the semiconductor mirror (22) consist of or include connecting semiconductors of the III and V main group of the periodic system and, in particular are doped with Si, Te, Zn, C, Mg and/or Se.

3. Multiple solar cell according to claim 1 or 2, **characterised in that** the layer, which is formed directly below the sub-cell (16) thereabove, of the semiconductor mirror (22) forms the rear side field of the sub-cell, which consists of, in particular, AlGaInP.

4. Multiple solar cell according to at least one of the preceding claims, **characterised in that** the layer or layers of the semiconductor mirror (22), which is or are arranged directly below the succeeding sub-cell (16), are lattice-matched to the sub-cell (16).

5. Multiple solar cell according to at least one of the preceding claims, **characterised in that** the semiconductor mirror (22) comprises materials with a band-gap energy equal to or greater than that of the sub-cell (16) thereabove.

6. Multiple solar cell according to at least one of the preceding claims, **characterised in that** the layers of the semiconductor mirror (22) consist of semiconductors in the form of AlGaInAs material and/or AlGaInP material, wherein, in particular, the AlgaInAs material includes GaAs, InAs, AlAs, GaInAs AlGaAs, AlInAs and/or the AlGaInP material includes GaP, InP AIP, Galop and/or AlInP.

7. Multiple solar cell according to at least one of the preceding claims, **characterised in that** the semiconductor mirror (22) consist of at least three layers with different index of refraction and/or of at least three layers with different composition and/or with different thickness.

8. Multiple solar cell according to any one of the preceding claims, **characterised in that** the semiconductor mirror (22) has a total thickness D with 500 nm ≤ D ≤ 4000 nm and wherein the semiconductor mirror (22) consists of n-layers with 15 ≤ n ≤ 35.

9. Multiple solar cell according to any one of the preceding claims, **characterised in that** the semiconductor mirror (22) has a total thickness D with 750 nm ≤ D ≤ 2500 nm.

10. Multiple solar cell according to any one of the preceding claims, **characterised in that** several semiconductor mirrors (22) are incorporated.

11. Multiple solar cell according to at least one of the preceding claims, **characterised in that** the reflectivity R of the semiconductor mirror (22) of the radiation in a part of the spectral absorption range of the sub-cell (16) or sub-cells (12, 14, 16) arranged above the semiconductor mirror amounts to 0.7 ≤ R ≤ 1.

12. Multiple solar cell according to at least one of the preceding claims, **characterised in that** the transmissivity T of the semiconductor mirror (22) of the radiation in the spectral absorption range of the sub-cell or sub-cells arranged below the semiconductor mirror mounts to 0.8 ≤ T ≤.

## Revendications

1. Cellule solaire monolithique multi-jonctions (10) composée essentiellement d'éléments des groupes III et V du système périodique, dans laquelle la cellule solaire multiple (10) comprend au moins trois cellules partielles (12, 14, 16, 18), parmi lesquelles une cellule partielle est une cellule partielle au GaInAs et est bâtie sur un substrat de Ge, **caractérisée en ce qu'**un miroir à semi-conducteur (22) est disposé en dessous de la cellule partielle au GaInAs et **en ce que** le miroir à semi-conducteur (22) comporte plusieurs couches qui présentent un indice de réfraction et/ou une composition de matière et/ou une épaisseur différent(e) l'une de l'autre, et dans laquelle l'épaisseur d des couches du miroir à semi-conducteur (22) vaut 10 nm ≤ d ≤ 150 nm et le miroir à semi-conducteur (22) se compose de n couches avec 10 ≤ n ≤ 50 et la demi-largeur HWB du miroir à semi-conducteur (22) vaut 50 nm ≤ HWB ≤ 300 nm et **en ce que** le miroir à semi-conducteur présente un degré de réflexion élevé dans une partie du domaine d'absorption spectral de la cellule partielle (16) ou des cellules partielles (12, 14, 16) disposée(s) au-dessus du miroir à semi-conducteur et un degré de transmission élevé dans le domaine d'absorption spectral de la cellule partielle (18) ou des cellules partielles disposée(s) en dessous du miroir à semi-conducteur.

2. Cellule solaire multi-jonctions selon la revendication 1, **caractérisée en ce que** les couches du miroir à semi-conducteur (22) sont constituées de semi-conducteurs composites des groupes III et V du système périodique ou en contiennent et sont en particulier dopées avec Si, Te, Zn, C, Mg et/ou Se.

3. Cellule solaire multi-jonctions selon la revendication 1 ou 2, **caractérisée en ce que** la couche du miroir à semi-conducteur (22) formée immédiatement en dessous de la cellule partielle sus-jacente (16) forme le champ arrière de la cellule partielle qui se compose en particulier d'AlGaInP.

4. Cellule solaire multi-jonctions selon au moins l'une des revendications précédentes, **caractérisée en ce que** la couche ou les couches du miroir à semi-conducteur (22), qui est/sont disposée(s) directement en dessous de la cellule partielle suivante (16) sont en correspondance de réseau avec la cellule partielle (16).

5. Cellule solaire multi-jonctions selon au moins l'une des revendications précédentes, **caractérisée en ce que** le miroir à semi-conducteur (22) présente des matériaux avec une énergie de bande interdite de valeur égale ou supérieure à la cellule partielle (16) située au-dessus.

6. Cellule solaire multi-jonctions selon au moins l'une des revendications précédentes, **caractérisée en ce que** les couches du miroir à semi-conducteur (22) se composent de semi-conducteurs composites sous la forme de matériau de AlGaInAs et/ou de matériau de AlGaInP, en particulier le matériau de AlGaInAs incluant GaAs, InAs, AlAs, GaInAs, AlGaAs, AlInAs et/ou le matériau de AlGaInP incluant GaP, InP, AIP, GaInP, et/ou AlInP.

7. Cellule solaire multi-jonctions selon au moins l'une des revendications précédentes, **caractérisée en ce que** le miroir à semi-conducteur (22) se compose d'au moins trois couches présentant un indice de réfraction différent et/ou d'au moins trois couches présentant une composition différente et/ou une épaisseur différente.

8. Cellule solaire multi-jonctions selon l'une quelconque des revendications précédentes, **caractérisée en ce que** le miroir à semi-conducteur (22) présente une épaisseur totale D avec 500 nm ≤ D ≤ 4 000 nm et dans lequel le miroir à semi-conducteur (22) se compose de n couches avec 15 ≤ n ≤ 35.

9. Cellule solaire multi-jonctions selon l'une quelconque des revendications précédentes, **caractérisée en ce que** le miroir à semi-conducteur (22) présente une épaisseur totale D avec 750 nm ≤ D ≤ 2 500 nm.

10. Cellule solaire multi-jonctions selon l'une quelconque des revendications précédentes, **caractérisée en ce que** plusieurs miroirs à semi-conducteur (22) sont incorporés.

11. Cellule solaire multi-jonctions selon au moins l'une des revendications précédentes, **caractérisée en ce que** le degré de réflexion R du miroir à semi-conducteur (22) du rayonnement dans une partie du domaine d'absorption spectral de la cellule partielle (16) ou des cellules partielles (12, 14, 16) disposée(s) au-dessus du miroir à semi-conducteur se situe à 0,7 ≤ R ≤ 1.

12. Cellule solaire multi-jonctions selon au moins l'une des revendications précédentes, **caractérisée en ce que** le degré de transmission T du miroir à semi-conducteur (22) du rayonnement dans le domaine d'absorption spectral de la cellule partielle ou des cellules partielles disposée(s) en dessous du miroir à semi-conducteur se situe à 0,8 ≤ T ≤ 1.
